# EUROPEAN PATENT APPLICATION

(11) **EP 3 889 584 A1**
(43) Date of publication of application: **06.10.2021**
(21) Application number: 19890530.9
(22) Date of filing: 07.11.2019
(51) Int. Cl.: G01N 21/64, C12M 1/00, C12M 1/34, G01N 21/03, G01N 33/483, G01N 33/68, H01L 31/02

(54) **CHIP FOR DETECTING MATERIAL DERIVED FROM LIVING BODY, APPARATUS FOR DETECTING MATERIAL DERIVED FROM LIVING BODY, AND SYSTEM FOR DETECTING MATERIAL DERIVED FROM LIVING BODY**

(30) Priority: 26.11.2018 JP 2018220688
(71) Applicant: Sony Semiconductor Solutions Corporation, Atsugi-shi, Kanagawa 243-0014 (JP)
(72) Inventor: MASUDA Yoshiaki, Atsugi-shi, Kanagawa 243-0014 (JP); NAKAJIKI Sintaro, Kikuchi-gun, Kumamoto 869-1102 (JP); OHKUBO Yuka, Kikuchi-gun, Kumamoto 869-1102 (JP); YAMAZAKI Tomohiro, Kikuchi-gun, Kumamoto 869-1102 (JP)
(74) Representative: Müller Hoffmann & Partner
(86) International application number: PCT/JP2019/043641
(87) International publication number: WO 2020/110646

(57) **Abstract**

To provide a chip for detecting a biological substance with high detection accuracy.

The present technology provides a chip for detecting a biological substance, including: a plurality of pixels, in which each of the pixels includes at least a holding surface for holding the biological substance and a photoelectric conversion unit that is provided below the holding surface and on a semiconductor substrate, and a color-mixture suppressing unit is provided between the pixels. Further, the present technology provides a biological-substance detection apparatus and a biological-substance detection system using the chip for detecting a biological substance.

## Description

### Technical Field

The present technology relates to a chip for detecting a biological substance, a biological-substance detection apparatus, and a biological-substance detection system.

### Background Art

In recent years, technological studies on genetic analysis, protein analysis, cellular analysis, etc. have been promoted in various fields such as medical field, drug discovery field, clinical examination field, food field, agricultural field, and engineering field. In particular, recently, detection technologies on a chip typified by a lab-on chip in which various reactions such as detection and analysis of biological substances such as nucleic acids, proteins, cells, and microorganisms are performed in a microscale channel or a well provided in a chip, been developed and put into practical use. These technologies have attracted attention as a method of easily measuring biological substances and the like.

For example, Patent Literature 1 discloses an optical detection apparatus including at least a first substrate in which a plurality of wells is formed; a second substrate provided with a heating means so as to be in contact with the well; a third substrate provided with a plurality of light irradiation means positioned corresponding to positions of the wells; and a fourth substrate provided with a plurality of light detection means positioned corresponding to the positions of the wells. In this optical detection apparatus, various reactions progressing in each well can be measured.

Further, for example, Patent Literature 2 discloses a chemical sensor including: a substrate in which an optical detection unit is formed; and a plasmon absorbing layer having a metallic nanostructure for giving a plasmon absorbing property, which is stacked on the substrate. In this chemical sensor, it is possible to detect the light emission caused by the bond of a probe material fixed on the sensor and a target material.

### Citation List

### Patent Literature

Patent Literature 1: Japanese Patent Application Laid-open No. 2010-284152
Patent Literature 2: WO2013/080473

### Disclosure of Invention

### Technical Problem

In the case where light emitted from a biological substance is detected in a plurality of regions (e.g., a plurality of wells) on a chip using a plurality of light detection units corresponding to the regions, there is a problem of leakage of light from an adjacent region into each of the light detection units. For example, in the case where different reactions are caused to progress in the respective regions and the light emission caused by each of the reactions is detected, there is a possibility that an erroneous determination is made by erroneously detecting the light emission from another region.

In this regard, it is a main object of the present technology to provide a chip for detecting a biological substance with high detection accuracy.

### Solution to Problem

That is, in the present technology, first, there is provided a chip for detecting a biological substance, including:
a plurality of pixels, in which
each of the pixels includes at least a holding surface for holding the biological substance and a photoelectric conversion unit that is provided below the holding surface and on a semiconductor substrate, and
a color-mixture suppressing unit is provided between the pixels.

In the chip for detecting a biological substance according to the present technology, the pixel and the color-mixture suppressing unit may have different conductivity types

In this case, the pixel may have an N-type region and the color-mixture suppressing unit may have a P-type region. Conversely, the pixel may have a P-type region and the color-mixture suppressing unit may have an N-type region.

In the chip for detecting a biological substance according to the present technology, each of the plurality of pixels may have a photoelectric conversion region, and a trench may be provided between the respective photoelectric conversion regions.

In this case, an interior of the trench may include one or more selected from an oxide film and a metal.

In the chip for detecting a biological substance according to the present technology, a recessed portion may be provided above the photoelectric conversion unit and on the holding surface.

In the chip for detecting a biological substance according to the present technology, the holding surface may be provided on a film formed on the semiconductor substrate.

In this case, the film may have a first refractive index and the semiconductor substrate may have a second refractive index different from the first refractive index.

Further, the film may include one or more films selected from an inorganic film and an organic film.

The chip for detecting a biological substance according to the present technology may further include light-shielding films provided above between the respective adjacent pixels.

A space between the light-shielding films may be formed to have one or more shapes selected from a circular shape, an elliptical shape, and a polygon having round corners in a top view.

In the chip for detecting a biological substance according to the present technology, the holding surface may be provided on an on-chip lens (OCL) provided on the semiconductor substrate.

In this case, the holding surface may also be provided on a flattening film formed on the on-chip lens (OCL).

Examples of a biological substance that can be detected by the chip for detecting a biological substance according to the present technology include one or more biological substances selected from nucleic acids, proteins, cells, microorganisms, chromosomes, liposomes, mitochondria, organelles, and complexes thereof.

Further, the present technology, there is provided a biological-substance detection apparatus including:
a chip for detecting a biological substance including a plurality of pixels; and
an analysis unit that analyzes electric information acquired by the chip for detecting a biological substance, in which
each of the pixels includes at least a holding surface for holding the biological substance and a photoelectric conversion unit that is provided below the holding surface and on a semiconductor substrate, and
a color-mixture suppressing unit is provided between the pixels.

Further, in the present technology, there is provided a biological-substance detection system including:
a chip for detecting a biological substance including a plurality of pixels; and
an analysis device that analyzes electric information acquired by the chip for detecting a biological substance, in which
each of the pixels includes at least a holding surface for holding the biological substance and a photoelectric conversion unit that is provided below the holding surface and on a semiconductor substrate, and
a color-mixture suppressing unit is provided between the pixels.

In the present technology, the "biological substance" is intended to broadly include nucleic acids, proteins, cells, microorganisms, chromosomes, liposomes, mitochondria, organelles, and complexes thereof. The cells include animal cells (e.g., hematopoietic cells) and plant cells. The microorganisms include bacteria such as Escherichia coli, viruses such as tobacco mosaic virus, and fungi such as yeast.

### Brief Description of Drawings

[Fig. 1] Fig. 1 is a schematic conceptual diagram schematically showing an interaction of a biological substance S that can be detected by a chip for detecting a biological substance 1, a biological-substance detection apparatus 2, and a biological-substance detection system 3 according to the present technology.
[Fig. 2] Fig. 2 is a schematic conceptual diagram schematically showing an interaction of the biological substance S that can be detected by the chip for detecting a biological substance 1, the biological-substance detection apparatus 2, and the biological-substance detection system 3 according to the present technology.
[Fig. 3] Fig. 3 is a schematic conceptual diagram schematically showing an interaction of the biological substance S that can be detected by the chip for detecting a biological substance 1, the biological-substance detection apparatus 2, and the biological-substance detection system 3 according to the present technology.
[Fig. 4] Fig. 4 is a schematic conceptual diagram schematically showing screening of another substance that can be performed by the chip for detecting a biological substance 1, the biological-substance detection apparatus 2, and the biological-substance detection system 3 according to the present technology.
[Fig. 5] Fig. 5 is a schematic conceptual diagram schematically showing screening of another substance that can be performed by the chip for detecting a biological substance 1, the biological-substance detection apparatus 2, and the biological-substance detection system 3 according to the present technology.
[Fig. 6] Fig. 6 is a schematic conceptual diagram schematically showing screening of another substance that can be performed by the chip for detecting a biological substance 1, the biological-substance detection apparatus 2, and the biological-substance detection system 3 according to the present technology.
[Fig. 7] Fig. 7 is a schematic cross-sectional view schematically showing a first embodiment of the chip 1 for detecting a biological substance according to the present technology.
[Fig. 8] Part A of Fig. 8 is a schematic cross-sectional view schematically showing a second embodiment of the chip 1 for detecting a biological substance according to the present technology, and Part B of Fig. 8 is a schematic cross-sectional view schematically showing a modified example of the second embodiment.
[Fig. 9] Fig. 9 is a schematic cross-sectional view schematically showing a third embodiment of the chip 1 for detecting a biological substance according to the present technology.
[Fig. 10] Fig. 10 is a schematic cross-sectional view schematically showing a fourth embodiment of the chip 1 for detecting a biological substance according to the present technology.
[Fig. 11] Fig. 11 is a schematic cross-sectional view schematically showing a fifth embodiment of the chip 1 for detecting a biological substance according to the present technology.
[Fig. 12] Fig. 12 is a schematic cross-sectional view schematically showing a sixth embodiment of the chip 1 for detecting a biological substance according to the present technology.
[Fig. 13] Fig. 13 is a schematic cross-sectional view schematically showing a seventh embodiment of the chip 1 for detecting a biological substance according to the present technology.
[Fig. 14] Fig. 14 is a schematic cross-sectional view schematically showing a eighth embodiment of the chip 1 for detecting a biological substance according to the present technology.
[Fig. 15] Fig. 15 is a schematic cross-sectional view schematically showing a ninth embodiment of the chip 1 for detecting a biological substance according to the present technology.
[Fig. 16] Fig. 16 is a schematic top plan view schematically showing an example of a light-shielding film 17 of the chip 1 for detecting a biological substance according to the present technology.
[Fig. 17] Fig. 17 is a schematic cross-sectional view schematically showing a tenth embodiment of the chip 1 for detecting a biological substance according to the present technology.
[Fig. 18] Fig. 18 is a schematic cross-sectional view schematically showing an eleventh embodiment of the chip 1 for detecting a biological substance according to the present technology.
[Fig. 19] Fig. 19 is a schematic cross-sectional view schematically showing a twelfth embodiment of the chip 1 for detecting a biological substance according to the present technology.
[Fig. 20] Fig. 20 is a schematic cross-sectional view schematically showing a thirteenth embodiment of the chip 1 for detecting a biological substance according to the present technology.
[Fig. 21] Fig. 21 is a schematic cross-sectional view schematically showing a fourteenth embodiment of the chip 1 for detecting a biological substance according to the present technology.
[Fig. 22] Fig. 22 is a schematic cross-sectional view schematically showing a fifteenth embodiment of the chip 1 for detecting a biological substance according to the present technology.
[Fig. 23] Fig. 23 is a schematic cross-sectional view schematically showing a sixteenth embodiment of the chip 1 for detecting a biological substance according to the present technology.
[Fig. 24] Fig. 24 is a schematic top plan view schematically showing a seventeenth embodiment of the chip 1 for detecting a biological substance according to the present technology.
[Fig. 25]Fig. 25 is a schematic cross-sectional view taken along line A-A of Fig. 24 omitting the inner structure.
[Fig. 26] Fig. 26 is a block diagram showing the concept of the biological-substance detection apparatus 2 according to the present technology.
[Fig. 27] Fig. 27 is a block diagram showing the concept of the biological-substance detection system 3 according to the present technology.

### Mode(s) for Carrying Out the Invention

Hereinafter, favorable embodiments for carrying out the present technology will be described with reference to the accompanying drawings. The embodiments described below illustrate an example of a typical embodiment of the present technology, which does not narrowly interpret the scope of the present technology. Note that description will be made in the following order.
1. Outline of detection of biological substance in present technology
   (1) Detection of biological substance S itself
   (2) Detection of interaction of biological substance S
   (3) Screening of other substances
2. Chip 1 for detecting biological substance
   (1) First Embodiment
   (2) Second Embodiment, Third Embodiment
   (3) Fourth Embodiment
   (4) Fifth Embodiment to Seventh Embodiment
   (5) Ninth Embodiment to Twelfth embodiment
   (6) Thirteenth embodiment, Fourteenth embodiment
   (7) Fifteenth embodiment
   (8) Sixteenth embodiment
   (9) Seventeenth embodiment
3. Biological-substance detection apparatus 2
4. Biological-substance detection system 3

### <1. Outline of detection of biological substance in present technology>

The outline of detection a biological substance S performed by a chip 1 for detecting a biological substance1, a biological-substance detection apparatus 2, and a biological-substance detection system 3 according to the present technology will be described. The chip 1 for detecting a biological substance, the biological-substance detection apparatus 2, and the biological-substance detection system 3 according to the present technology can be used for (1) detection of the biological substance S itself, (2) detection of an interaction of the biological substance S, (3) screening of another substance (e.g., medicinal active ingredient) using the biological substance S, and the like. Note that the respective detections are performed by a holding surface 111 of the chip 1 for detecting a biological substance to be described later.

### (1) Detection of biological substance S itself

For example, the present technology can be used to detect biological substances such as erythrocytes, leukocytes, platelets, cytokines, hormonal substances, sugars, lipids, and proteins, which are contained in body fluid such as blood, urine, stool, and saliva; microorganisms such as bacteria, fungi, and viruses in body fluid and water; genes in cells and microorganisms, and the like. For example, after staining using a dye that specifically acts on a substance to be detected or a material to be not detected, the presence of the substance to be detected can be detected by the presence or absence of the target photodetection. The detected result can be used for diagnosis of a disease, diagnosis of a body environment, examination of water quality, and the like.

### (2) Detection of interaction of biological substance S

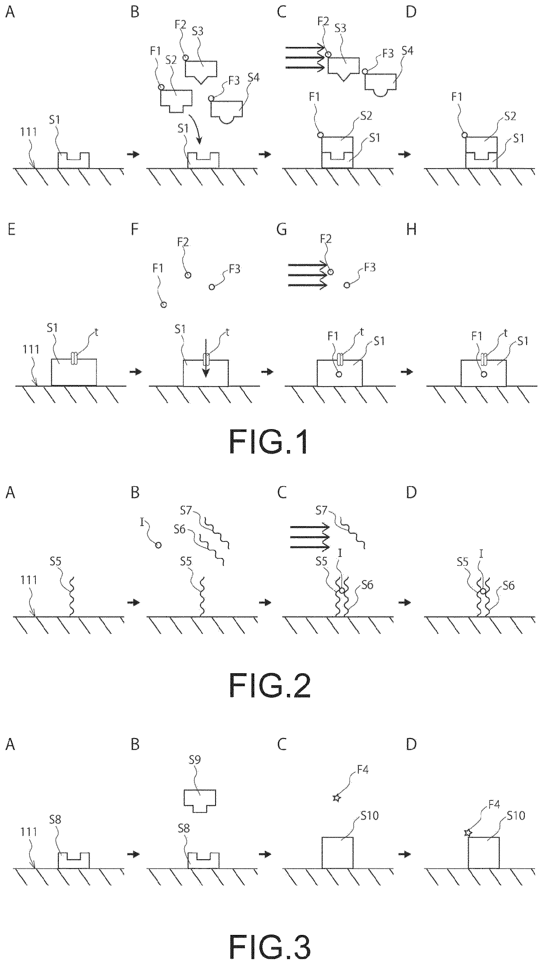

For example, the present technology can be used to detect interactions such as interactions of proteins, hybridizations of nucleic acids, and binding of cytokines or hormonal substances to receptors. A specific detection example will be described with reference to Figs. 1 to 3.

For example, as shown in Part A to D of Fig. 1, the biological substance S1 such as proteins and receptors (or those simulating receptors) is fixed to a holding surface 111 (see Part A of Fig. 1), and biological substance S2 to S4 for which the interaction with the biological substance S1 are checked are added, dyes such as fluorescent dyes F1 to F3 being respectively fixed to the biological substance S2 to S4 (see Part B in Fig. 1). Then, the biological substances S3 and S4 that have not interacted with the biological substance S1 are washed (see Part C of Fig. 1), and the fluorescent dye F1 is detected from the holding surface 111 (see Part D of Fig. 1), whereby the interaction between the biological substance S1 and the biological substance S2 can be detected.

For example, as shown in Parts E to H of Fig. 1, the biological substance S1 such as a cell is fixed to the holding surface 111, the light emitter F1 that is taken in via a transporter t of the biological substance S1 (e.g., a transporter in the cell membrane) can be detected.

For example, as shown in Parts A to D of Fig. 2, a probe S5 including a DNA, an RNA, or the like is fixed to the holding surface 111 (see Part A of Fig. 2), and samples containing DNAs S6 and S7, which may be targets, and an intercalator I are added (see Part B of Fig. 2). Then, when the DNA S6 having a sequence complementary to the probe S5 is contained in the sample, a hybridization reaction occurs. The DNA S7 that has not been hybridized (see Part C of Fig. 2) is washed, and the light emitted from the intercalator I from the holding surface 111 is detected (see D in Fig. 2), whereby hybridization of the probe S5 and the target DNA S6 can be detected.

For example, as shown in Parts A to D of Fig. 3, a biological substance S8 is fixed to the holding surface 111 (see Part A of Fig. 3), and a biological substance S9 that interacts with the biological substance S8 to form a new substance S10 is added (see Part B of Fig. 3). Next, a dye such as a fluorescent dye F4 that specifically binds to the substance S10 is added (see Part C of Fig. 3), and the fluorescent dye F4 is detected from the holding surface 111 (see Part D of Fig. 3), whereby the interaction between the biological substance S8 and the biological substance S9 can be detected.

### (3) Screening of other materials

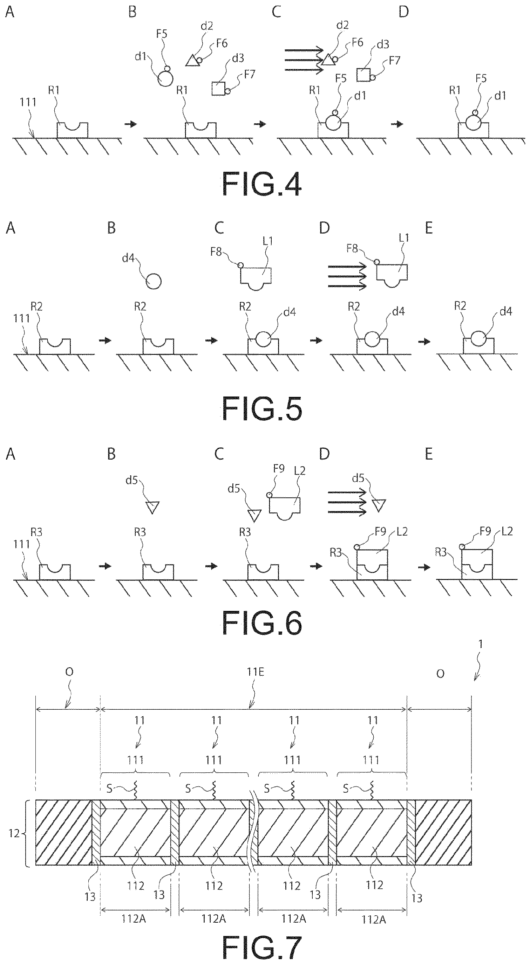

For example, the present technology can be used to perform screening of substances, which may be agonists or antagonists of various receptors, and screening of inhibitors of the production of various microorganisms, antimicrobials, bactericides, and the like. A specific detection example will be described with reference to Figs. 4 to 6.

For example, as shown in Parts A to D of Fig. 4, a receptor R1 (or those simulating the receptor R1) is fixed to the holding surface 111 (see Part A of Fig. 4), and substances d1 to d3 for checking the agonism of the receptor R1 are added, dyes such as fluorescent dyes F5 to F7 being respectively fixed to the substances d1 to d3 (see Part B of Fig. 4). Then, the substances d2 and d3 that have not bound to the receptor R1 are washed (see Part C of Fig. 4), and the fluorescent dye F5 is detected from the holding surface 111 (see Part D of Fig 3), whereby screening of the substance d1 that can be an agonist of the receptor R1 can be performed.

For example, as shown in Parts A to E of Fig. 5, a receptor R2 (or a those simulating the receptor R2) is fixed to the holding surface 111 (see Part A of Fig. 5), and a substance d4 for checking the antagonism of this receptor R2 is added (see Part B of Fig. 5). Next, a ligand L1 that binds to the receptor R2 is added, a dye such as a fluorescent dye F8 being fixed to the ligand L1 (see Part C of Fig. 5). At this time, in the case where the substance d4 can be an antagonist of the receptor R2, the ligand L1 cannot bind to the receptor R2 because the receptor R2 and the substance d4 are bound to each other (see Part C of Fig. 5). Even when an attempt is made to detect the fluorescent dye F8 from the holding surface 111 after washing the ligand L1 that has not bound to the receptor R2 in this state (see Part D of Fig. 5), no light is detected because the fluorescent dye F8 is not present on the holding surface 111 by washing (see Part E of Fig. 5).

Meanwhile, for example, as shown in Parts A to E of Fig. 6, a receptor R3 (or those simulating the receptor R3) is fixed to the holding surface 111 (see Part A of Fig. 6), and a substance d5 for checking the antagonism of this receptor R3 is added (see Part B of Fig. 6). Next, a ligand L2 that binds to the receptor R3 is added, a dye such as a fluorescent dye F9 being fixed to the ligand L2 (see Part C of Fig. 6). At this time, in the case where the substance d5 cannot be an antagonist of the receptor R3, the ligand L2 binds to the receptor R3 (see Part D of Fig. 6). When the substance d5 that has not bound to the receptor R3 is washed (see Part D of Fig. 6), the fluorescent dye F9 is detected from the holding surface 111 (see Part E of Fig. 6).

In this way, as shown in Fig. 5 and Fig. 6, the presence or absence of detection of fluorescent dye F8 or the fluorescent dye F9 from the holding surface 111 can be used to perform screening of the substance d4 that can be an antagonist of the receptor R3.

### <2. Chip 1 for detecting biological substance>

The chip 1 for detecting a biological substance according to the present technology includes a plurality of pixels 11, each of the pixels includes at least the holding surface 111 for holding the biological substance S and a photoelectric conversion unit 112 that is provided below the holding surface 111 and on a semiconductor substrate 12. Then, a color-mixture suppressing unit 13 is provided between the pixels 11. Hereinafter, description will be made with reference to each embodiment.

### (1) First embodiment

Fig. 7 is a schematic cross-sectional view schematically showing a first embodiment of the chip 1 for detecting a biological substance according to the present technology. The chip 1 for detecting a biological substance according to the first embodiment includes an effective pixel region 11E in which the plurality of pixels 11 is two-dimensionally arranged in a matrix. Each of the pixels 11 includes at least the holding surface 111 for holding the biological substance S and the photoelectric conversion unit 112. For the photoelectric conversion unit 112, for example, a photoelectric conversion element such as a photodiode can be freely used. Further, although not illustrated, each of the pixels 11 may include a pixel circuit including a charge accumulation unit, a plurality of transistors, a capacitive element, and the like. An optical black pixel, a wiring region, and the like (not shown) may be provided on the outside O of the effective pixel region 11E.

The holding surface 111 is not particularly limited as long as it has a configuration in which the biological substance S can be held, and surface treatment can be freely used. For example, the holding surface 111 can be formed by applying a photosensitive silane coupling agent or the like, which is modified to be hydrophilic by being irradiated with ultraviolet rays and selectively irradiating a region in which the biological substance S is desired to be held with ultraviolet rays. Further, for example, when the holding surface 111 is subjected to avidin treatment, the biological substance S such as a nucleic acid whose one end is biotinylated can be held by the avidin-biotin bond.

Further, a light-shielding film 17 described below, a partition wall, or the like is provided above (upper side of the chip surface) between the adjacent pixels 11 so that a liquid can be held on the surface of the chip 1, whereby the biological substance S can be held in the liquid.

The color-mixture suppressing unit 13 is provided between the pixels 11. In the first embodiment of the chip 1 for detecting a biological substance according to the present technology, by making the pixel 11 and the color-mixture suppressing unit 13 have different conductivity types, color-mixture between the adjacent pixels 11 is suppressed. Specifically, for example, the pixel 11 has an N-type region and a space between the pixels 11 is a P-type region. Conversely, the pixel 11 has a P-type region and the pixel 11 has an N-type region. As a result, the color-mixture between the adjacent pixels 11 can be suppressed.

Note that, in the first embodiment shown in Fig. 7, the biological substance S is described for illustrative purposes, but the biological substance S is not encompassed in the chip 1 for detecting a biological substance according to the present technology.

### (2) Second embodiment, third embodiment

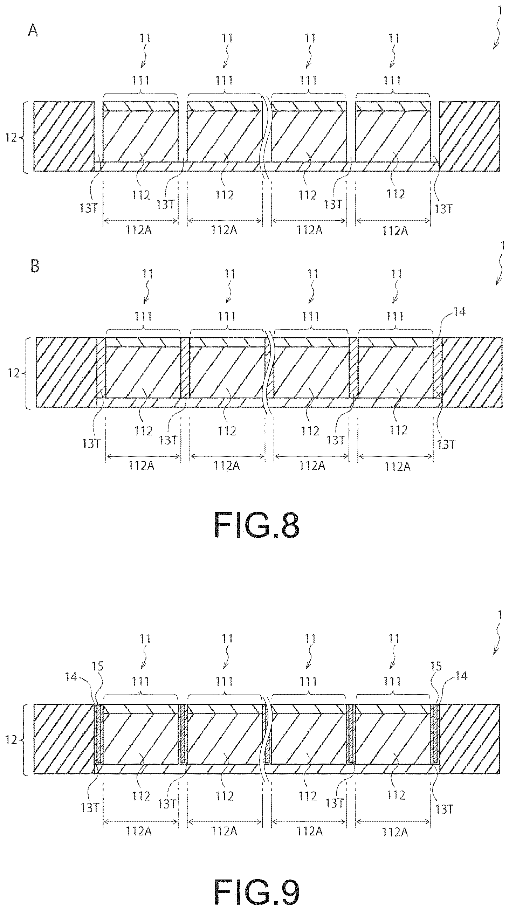

Part A of Fig. 8 is a schematic cross-sectional view schematically showing a second embodiment of the chip 1 for detecting a biological substance according to the present technology, and Part B of Fig. 8 is a schematic cross-sectional view schematically showing a modified example of the second embodiment. The chip 1 for detecting a biological substance according to the second embodiment includes a trench 13T between photoelectric conversion regions 112A and this trench 13T functions as the color-mixture suppressing unit 13.

As shown in Part B of Fig. 8, an oxide film 14 may be provided inside the trench 13T. Examples of the material of the oxide film 14 include a material having a negative fixed charges, such as hafnium oxide (HfO₂), aluminum oxide (Al₂O₃), and tantalum oxide (Ta₂O₅). One of these oxide films may be provided as a single film, or a plurality of films may be stacked and provided. By providing an oxide film, it is suppress a dark current and an erroneous determination.

Inside the trench 13T, as in the third embodiment shown in Fig. 9, the oxide film 14, a metal 15, and the like can be provided. By providing the metal 15, the light shielding effect can be enhanced, and it is possible to suppress color-mixture into the adjacent pixel and an erroneous determination. By providing the oxide film 14 and the metal 15 inside the trench 13T, it is possible to improve the color-mixture suppressing effect between the adjacent pixels 11 while suppressing the dark current.

As the oxide film 14, the oxide film described in Fig. 8 can be used. That is, a silicon oxide film (SiO₂ film), a hafnium oxide film (HfO₂ film), an aluminum oxide film (Al₂O₃ film), a tantalum oxide film (Ta₂O₅ film), and the like can be used.

As the metal, for example, tungsten (W), aluminum (Al), copper (Cu), or titanium (Ti) can be used.

Note that in the second embodiment and the third embodiment, the other structures are the same as those in the first embodiment described above, and therefore description thereof will be omitted here. Also in other embodiments, only portions different from those in the first embodiment will be described below.

### (3) Fourth embodiment

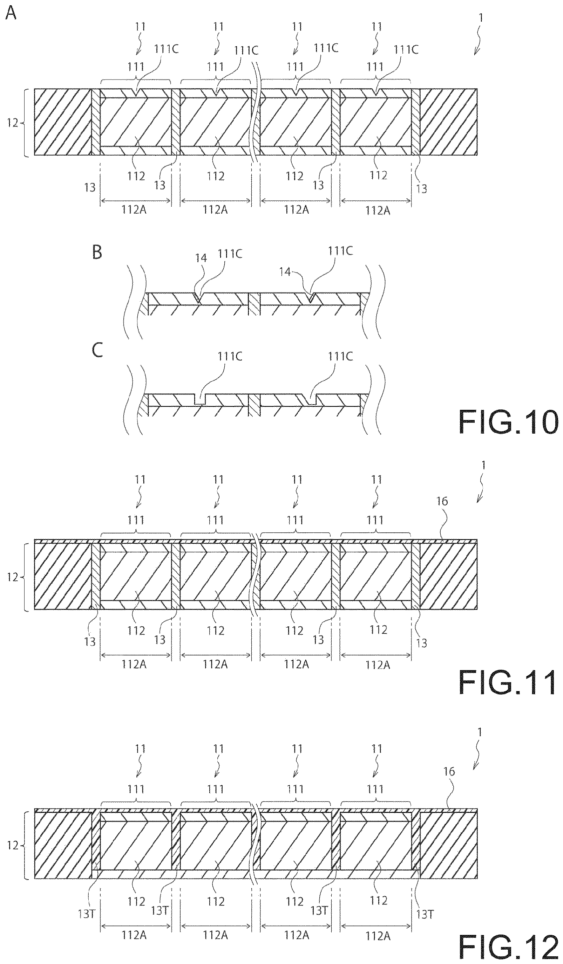

Part A of Fig. 10 is a schematic cross-sectional view schematically showing a fourth embodiment of the chip 1 for detecting a biological substance according to the present technology. In the chip 1 for detecting a biological substance according to the fourth embodiment, a recessed portion 111C is provided above the photoelectric conversion unit 112 and in the holding surface 111. By holding, on this recessed portion 111C, the biological substance S to be detected, light from the biological substance S can be prevented from scattering.

As shown in Part B of Fig. 10, the oxide film 14 may be provided in the recessed portion 111C. By providing the oxide film 14, it is possible to eliminate a color-mixture path and improve the sensitivity.

Further, the shape of the recessed portion 111C is not particularly limited. In addition to the substantially triangular shape in a cross-sectional view as shown in Parts A and B of Fig. 10, the recessed portion 111C can be designed to have a substantially square shape in a cross-sectional view, a substantially trapezoidal shape in a cross-sectional view as shown in Part C of Fig. 10, a substantially semicircular shape in a cross-sectional view although not shown, or the like.

### (4) Fifth embodiment to seventh embodiment

Fig. 11 is a schematic cross-sectional view schematically showing a fifth embodiment of the chip 1 for detecting a biological substance according to the present technology. In the chip 1 for detecting a biological substance according to the fifth embodiment, the holding surface 111 is provided on a film 16 formed on the semiconductor substrate 12.

As the film 16, one or two or more kinds of films formed on the semiconductor substrate 12 can be freely selected in accordance with the purpose. For example, an inorganic film such as a silicon oxide film (SiO₂ film), a silicon nitride film (Si₃N₄ film), a silicon oxynitride film (SiON film), a hafnium oxide film (HfO film), an aluminum oxide film (Al₂O₃ film), and a tantalum oxide film (Ta₂O₅ film), or an organic film formed a resin material such as a styrene resin, an acrylic resin, a styrene-acrylic copolymer resin, and a siloxane resin can be selected.

It is favorable that the refractive index of the film 16 is different from that of the semiconductor substrate 12. In other words, it is favorable that the film 16 has a first refractive index and the semiconductor substrate 12 has a second refractive index different from the first refractive index. The refractive index of the film 16 and the refractive index of the semiconductor substrate 12 differ, enabling angular-dependent optical designs of reflectance. Of the light from the biological substance S held on the holding surface 111, the light in the lateral direction can be reflected to prevent it from entering the semiconductor substrate 12. As a result, it is possible to suppress color-mixture between the pixels 11.

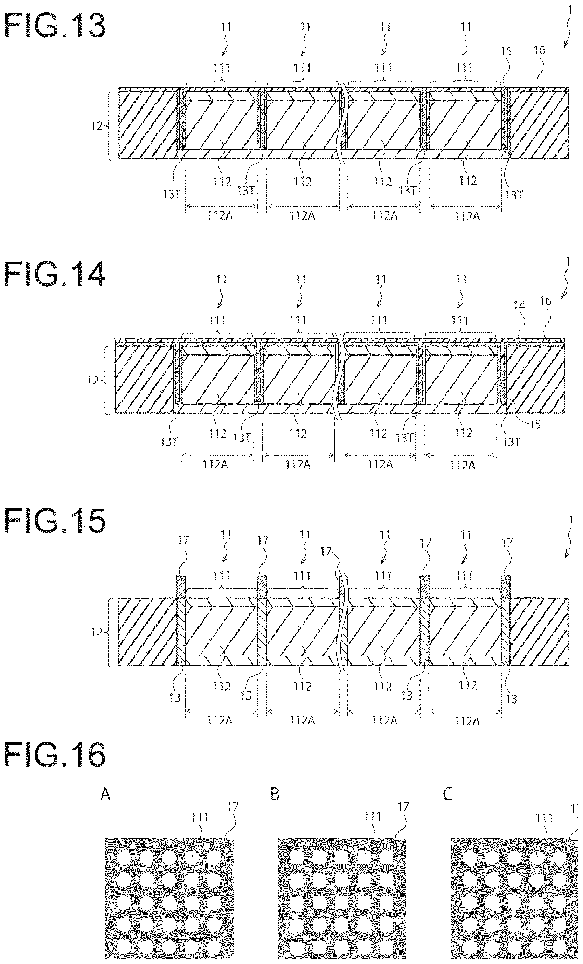

The film 16 may also be included in the trench 13T described above, as in a sixth embodiment to an eighth embodiment shown in Figs. 12 to 14. Further, the film 16 may be formed by stacking a plurality of films 16 or may be stacked with the oxide film 14 as in the eighth embodiment shown in Fig. 14, in accordance with the purpose.

### (5) Ninth embodiment to twelfth embodiment

Fig. 15 is a schematic cross-sectional view schematically showing a ninth embodiment of the chip 1 for detecting a biological substance according to the present technology. The chip 1 for detecting a biological substance according to the ninth embodiment includes the light-shielding film 17 provided above between the adjacent pixels 11. By providing the light-shielding film 17, it is possible to further suppress color-mixture between the pixels 11. Further, by providing the light-shielding film 17, it is possible to hold a liquid sample on the holding surface 111 and hold the biological substance S in the liquid.

As the light-shielding film 17, a film can be freely selected as long as it is a film formed of a material capable of blocking light. For example, a metallic film such as tungsten (W), aluminum (Al), copper (Cu), and titanium (Ti), or an optical black filter can be used.

The form of the light-shielding film 17 is not particularly limited and can be freely designed in accordance with the purpose. However, as shown in Parts A to C of Fig. 16, it is favorable that the light-shielding film 17 (i.e., the holding surface 111) has one or more shapes selected from a circular shape, an elliptical shape, and a polygon having round corners in a top view. By eliminating the corner in a top view between the light-shielding films 17 as described above, it is possible to suppress unevenness in the supply of the samples to the holding surface 111 when the samples are supplied, and insufficient washing when the holding surface 111 is washed. As a result, it is possible to further improve the detection accuracy.

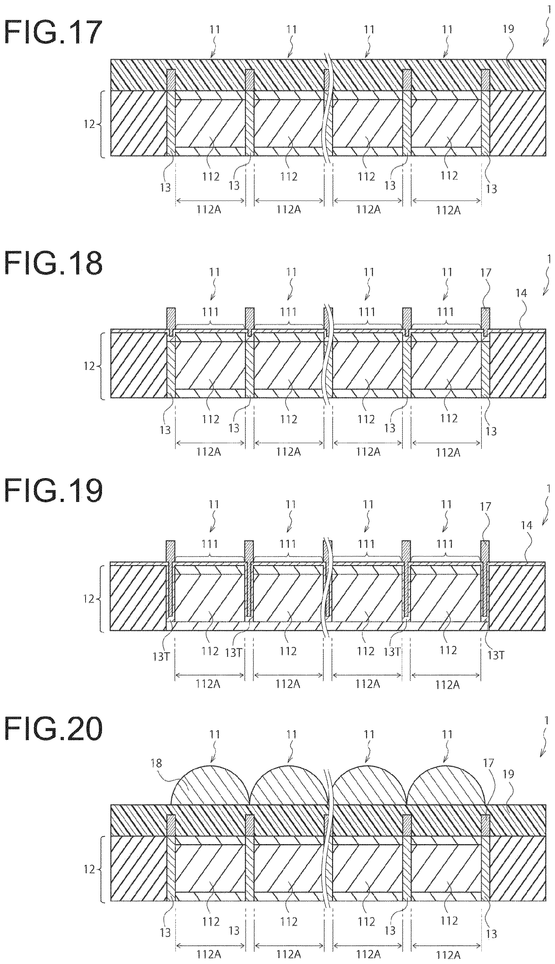

As another method of suppressing unevenness in the supply of the samples to the holding surface 111 when the samples are supplied and insufficient washing when the holding surface 111 is washed, a method of providing a flattening film 19 using an organic film or the like can be employed, as in a tenth embodiment shown in Fig. 17.

Another film such as the oxide film 14 may be provided below the light-shielding film 17 as in an eleventh embodiment shown in Fig. 18. Further, the light-shielding film 17 can also be embedded in the trench 13T described above to form a light shielding wall from above between the pixels 11 to the semiconductor substrate 12, as in a twelfth embodiment shown in Fig. 19.

Note that as shown in Fig. 15 to Fig. 19, the light-shielding film 17 may be provided for each of the pixels 11, but the light-shielding film 17 may be provided for a plurality of pixels 11.

### (6) Thirteenth embodiment, Fourteenth embodiment

Fig. 20 is a schematic cross-sectional view schematically showing a thirteenth embodiment of the chip 1 for detecting a biological substance according to the present technology. In the chip 1 for detecting a biological substance according to the thirteenth embodiment, the holding surface 111 is provided above an on-chip lens (OCL) 18 provided on the semiconductor substrate 12. By providing the on-chip lens (OCL), light from the biological substance S can be collected on the photoelectric conversion unit 112, and color-mixture between the pixels 11 can be further suppressed.

The specific structure of the on-chip lens (OCL) 18 is not particularly limited, and a structure (antireflection layer or the like) of an on-chip lens (OCL) can be freely selected and used.

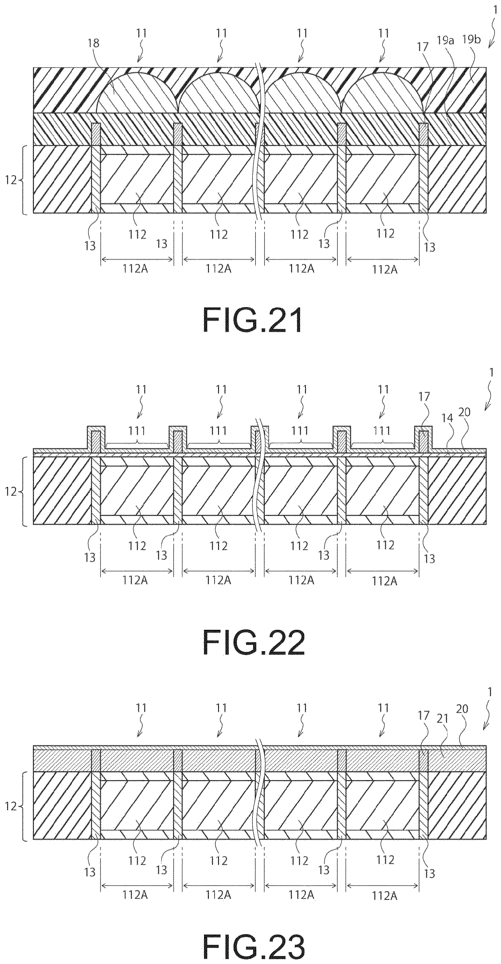

The on-chip lens (OCL) 18 may include the flattening film 19 as in a fourteenth embodiment shown in Fig. 21. In other words, the holding surface 111 may be provided on the flattening film 19 formed on the on-chip lens (OCL) 18. By providing the flattening film 19, it is possible to suppress unevenness in the supply of the samples to the holding surface 111 when the samples are supplied, insufficient washing when the holding surface 111 is washed, and the like. As a result, it is possible to further improve the detection accuracy.

In the fourteenth embodiment shown in Fig. 21, a flattening film 19a for flattening the light-shielding film 17 and a flattening film 19b for flattening the on-chip lens (OCL) are provided. The flattening films 19a and 19b may be formed of different materials or may be formed of the same material.

### (7) Fifteenth embodiment

Fig. 22 is a schematic cross-sectional view schematically showing a fifteenth embodiment of the chip 1 for detecting a biological substance according to the present technology. The chip 1 for detecting a biological substance according to the fifteenth embodiment includes a protective film 20 on the surface of the chip. By providing the protective film 20, it is possible to improve weatherability to heat, light, water, acids, alkalis, agents, and the like, and can also be contacted with water, acids, alkalis, or agents for extended periods of time.

As a material for forming the protective layer 20, any material having weatherability to heat, light, water, acids, alkalis, medicines, and the like can be freely selected and used in accordance with the purpose. Examples thereof include silicon oxide (SiO₂) , silicon nitride (Si₃N₄), and silicon oxynitride (SiON).

### (8) Sixteenth embodiment

Fig. 23 is a schematic cross-sectional view schematically showing a sixteenth embodiment of the chip 1 for detecting a biological substance according to the present technology. The chip 1 for detecting a biological substance according to the sixth embodiment includes an excitation light cut filter 21. By providing the excitation light cut filter 21, the excitation light can be prevented from leaking into the photoelectric conversion unit 112. As a result, it is possible to further improve the detection accuracy.

### (9) Seventeenth embodiment

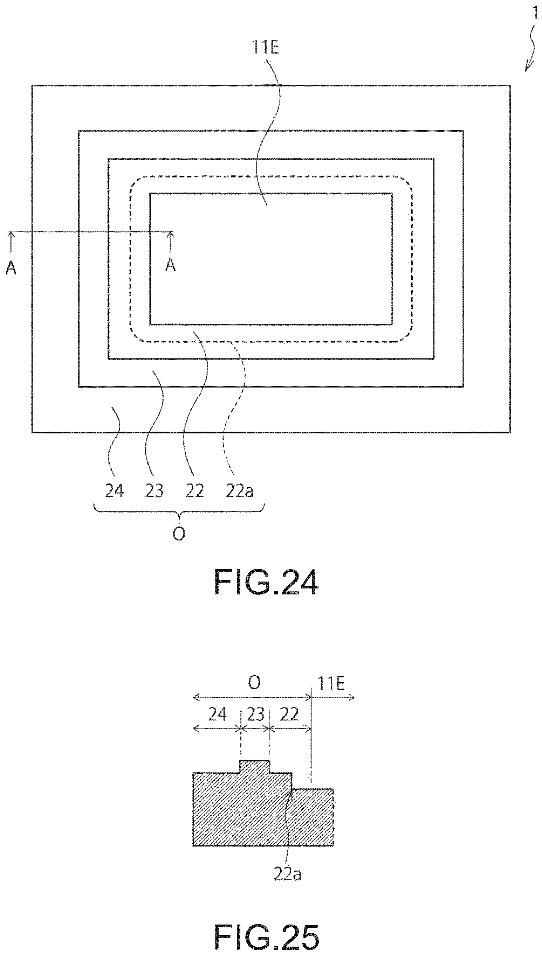

Fig. 24 is a schematic top plan view schematically showing a seventeenth embodiment of the chip 1 for detecting a biological substance according to the present technology. Fig. 25 is a schematic cross-sectional view taken along line A-A of Fig. 24 omitting the inner structure. The chip 1 for detecting a biological substance according to the seventeenth embodiment includes a stepped portion 22a is provided on the outside O of the effective pixel region 11E. More specifically, in the chip 1 for detecting a biological substance according to the seventeenth embodiment, an intermediate region 22, a wiring region 23, and a peripheral region 24 are provided from the effective pixel region 11E toward the outside, and the stepped portion 22a is provided in the intermediate region 22. The wiring region 23 provided on the outside O of the effective pixel region 11E is generally stepped. However, in the seventeenth embodiment, by providing the stepped portion 22a in the intermediate region 22 between the wiring region 23 and the effective pixel region11E, it is possible to suppress unevenness in the supply of the samples to the holding surface 111 when the samples are supplied, insufficient washing when the holding surface 111 is washed, and the like. As a result, it is possible to further improve the detection accuracy.

As shown in Fig. 24, in the seventh embodiment, the corners of the stepped portion 22a are formed in a round shape in a top view. By forming the corners of the stepped portion 22a in a round shape, it is possible to further suppress unevenness in the supply of the samples to the holding surface 111 when the samples are supplied, insufficient washing when the holding surface 111 is washed, and the like. Note that although not shown, the corners of the wiring region 23 can be formed in a round shape in a top view. Further, although not shown, a step portion can be provided in the peripheral region 24.

Note that although not shown, by providing the wiring region 23 on the surface side of chip1 opposite to the holding surface 111 (light-receiving surface), it is also possible to suppress unevenness in the supply of the samples to the holding surface 111 when the samples are supplied, insufficient washing when the holding surface 111 is washed, and the like.

### <3. Biological-substance detection apparatus 2>

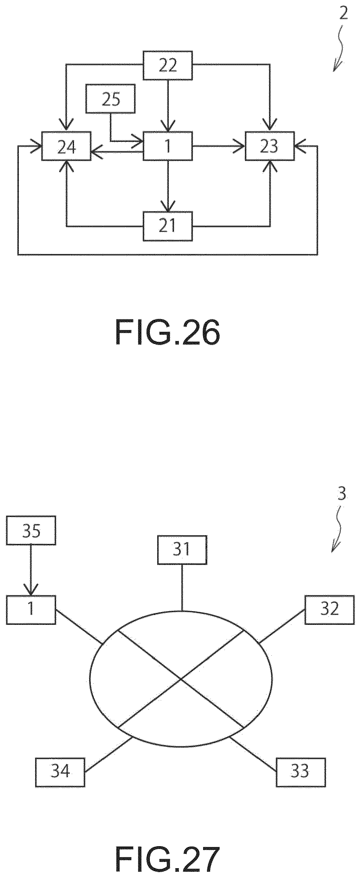

Fig. 26 is a block diagram showing the concept of the biological-substance detection apparatus 2 according to the present technology. The biological-substance detection apparatus 2 according to the present technology includes at least the above-mentioned chip 1 for detecting a biological substance according to the present technology, and an analysis unit 21. Further, the biological-substance detection apparatus 2 may further include a light irradiation unit 22, a storage unit 23, a display unit 24, a temperature control unit 25, and the like in accordance with the purpose. The respective units will be described below. Note that since the chip 1 for detecting a biological substance is as described above, description thereof is omitted here.

### (1) Analysis unit 21

In the analysis unit 21, the electric information acquired by the chip 1 for detecting a biological substance is analyzed. For example, on the basis of the electric information acquired by the chip 1 for detecting a biological substance, screening of the presence or absence of the biological substance S, the presence or absence of an interaction in the biological substance S, a medicinal active ingredient, and the like is performed.

Note that the analysis unit 21 may be implemented by a personal computer or a CPU, and may be stored as a program in a hardware resource including a recording medium (e.g., a non-volatile memory (USB memory), an HDD, or a CD) and operated by a personal computer or a CPU.

### (2) Light irradiation unit 22

The biological-substance detection apparatus 2 according to the present technology may include the light irradiation unit 22 for applying excitation light, for example. In the light irradiation unit 22, the biological substance S held on the holding surface 111 of the chip for detecting a biological substance1 is irradiated with light. Note that in the biological-substance detection apparatus 2 according to the present technology, the light irradiation unit 22 does not necessarily need to be provided, and the biological substance S can be irradiated with light using an external light irradiation device or the like.

The type of the light emitted from the light irradiation unit 22 is not particularly limited, but light having a constant light direction, wavelength, and light intensity is desirable in order to reliably generate fluorescent light or scattered light from fine particles. Examples thereof include lasers and LEDs. In the case of using a laser, the type of the laser is not particularly limited, and one or two or more of an argon ion (Ar) laser, a helium-neon (He-Ne) laser, a dye laser, a krypton (Cr) laser, a semiconductor laser, or a solid-state laser combining a semiconductor laser and a wavelength-conversion optical element, and the like can be freely used in combination.

The light irradiation unit 22 may include a plurality of light irradiation units 22 in accordance with the purpose. For example, one light irradiation unit 22 may be provided for each of the pixels 11 of the chip 1 for detecting a biological substance. Further, by stacking a substrate in which light-emitting elements such as LEDs are arranged at positions corresponding to the pixels 11 of the chip 1 for detecting a biological substance on the chip 1 for detecting a biological substance, the biological substance S can be irradiated with light.

### (3) Storage unit 23

The biological-substance detection apparatus 2 according to the present technology may include the storage unit 23 that stores various types of information. The storage unit 23 is capable of storing all items relating to detection, such as the electric data acquired by the chip 1 for detecting a biological substance, the analysis data generated by the analysis unit 21, and the optical data obtained by irradiation by the light irradiation unit 22.

In the biological-substance detection apparatus 2 according to the present technology, the storage unit 23 does not necessarily need to be provided and an external storage device may be connected. As the storage unit 23, for example, a hard disk or the like can be used.

### (4) Display unit 24

The biological-substance detection apparatus 2 according to the present technology may include the display unit 24 that displays various types of information. In the display unit 24, all items relating to detection, such as the electric data acquired by the chip 1 for detecting a biological substance, the analysis data generated by the analysis unit 21, the optical data obtained by irradiation by the light irradiation unit 22, and the data stored in the storage unit 23, can be displayed.

In the biological-substance detection apparatus 2 according to the present technology, the display unit 24 does not necessarily need to be provided, and an external display device may be connected. As the display unit 24, for example, a display, a printer, or the like can be used.

### (5) Temperature control unit 25

The biological-substance detection apparatus 2 according to the present technology may include a temperature control unit 25 for keeping the biological substance S held on the holding surface 111 of the chip 1 for detecting a biological substance at a predetermined temperature or for heating or cooling the biological substance S to a predetermined temperature. For example, in the case where the biological substance S is an enzyme, temperature control can be performed so as to keep the optimum temperature by the temperature control unit 25. Further, in the case where, for example, the biological substance S is a nucleic acid and the presence or absence of hybridization is detected using the present technology, the temperature can be controlled by the temperature control unit 25 so as to keep it within a temperature range in which hybridization can be performed. As the temperature control unit 25, a thermoelectric element such as a Peltier element can be used.

The temperature control unit 25 may include a plurality of temperature control units 25 in accordance with the purpose. For example, one temperature control unit 25 may be provided for each of the pixels 11 of the chip 1 for detecting a biological substance. Further, by stacking a substrate in which thermoelectric elements are arranged at positions corresponding to the pixels 11 of the chip 1 for detecting a biological substance on the pixels 11 of the chip 1 for detecting a biological substance, temperature control can be performed on the biological substance S.

Note that in the biological-substance detection apparatus 2 according to the present technology, the temperature control unit 25 does not necessarily need to be provided, and an external temperature control device or the like may be used to perform temperature control of the biological substance S.

### <4. Biological-substance detection system 3>

Fig. 27 is a block diagram showing the concept of the biological-substance detection system 3 according to the present technology. The biological-substance detection system 3 according to the present technology includes at least the above-mentioned chip 1 for detecting a biological substance according to the present technology, and an analysis device 31 In addition, the biological-substance detection system 3 may further include a light irradiation device 32, a storage device 33, a display device 34, a temperature control device 35, and the like in accordance with the purpose.

The chip 1 for detecting a biological substance and the respective devices may be connected to each other via wired or radio networks. Note that the details of each device are the same as the details of each unit of the biological-substance detection apparatus 2 according to the present technology, and therefore description thereof will be omitted here.

It should be noted that the present technology may also takes the following configurations.
(1) A chip for detecting a biological substance, including:
   a plurality of pixels, in which
   each of the pixels includes at least a holding surface for holding the biological substance and a photoelectric conversion unit that is provided below the holding surface and on a semiconductor substrate, and
   a color-mixture suppressing unit is provided between the pixels.
(2) The chip for detecting a biological substance according to (1), in which
   the pixel and the color-mixture suppressing unit have different conductivity types.
(3) The chip for detecting a biological substance according to (2), in which
   the pixel has an N-type region and the color-mixture suppressing unit has a P-type region.
(4) The chip for detecting a biological substance according to (2), in which
   the pixel has a P-type region and the color-mixture suppressing unit has an N-type region.
(5) The chip for detecting a biological substance according to any one of (1) to (4), in which
   each of the plurality of pixels has a photoelectric conversion region, and a trench is provided between the respective photoelectric conversion regions.
(6) The chip for detecting a biological substance according to (5), in which
   an interior of the trench includes one or more selected from an oxide film and a metal.
(7) The chip for detecting a biological substance according to any one of (1) to (6), in which
   a recessed portion is provided above the photoelectric conversion unit and on the holding surface.
(8) The chip for detecting a biological substance according to any one of (1) to (7), in which
   the holding surface is provided on a film formed on the semiconductor substrate.
(9) The chip for detecting a biological substance according to (8), in which
   the film has a first refractive index and the semiconductor substrate has a second refractive index different from the first refractive index.
(10) The chip for detecting a biological substance according to (8) or (9), in which
   the film includes one or more films selected from an inorganic film and an organic film.
(11) The chip for detecting a biological substance according to any one of (1) to (10), further including
   light-shielding films provided above between the respective adjacent pixels.
(12) The chip for detecting a biological substance according to (11), in which
   a space between the light-shielding films is formed to have one or more shapes selected from a circular shape, an elliptical shape, and a polygon having round corners in a top view.
(13) The chip for detecting a biological substance according to any one of (1) to (12), in which
   the holding surface is provided on an on-chip lens (OCL) provided on the semiconductor substrate.
(14) The chip for detecting a biological substance according to (13), in which
   the holding surface is provided on a flattening film formed on the on-chip lens (OCL).
(15) The chip for detecting a biological substance according to any one of (1) to (14), in which
   the biological substance is one or more biological substances selected from nucleic acids, proteins, cells, microorganisms, chromosomes, liposomes, mitochondria, organelles, and complexes thereof.
(16) A biological-substance detection apparatus, including:
   a chip for detecting a biological substance including a plurality of pixels; and
   an analysis unit that analyzes electric information acquired by the chip for detecting a biological substance, in which
   each of the pixels includes at least a holding surface for holding the biological substance and a photoelectric conversion unit that is provided below the holding surface and on a semiconductor substrate, and
   a color-mixture suppressing unit is provided between the pixels.
(17) A biological-substance detection system, including:
   a chip for detecting a biological substance including a plurality of pixels; and
   an analysis device that analyzes electric information acquired by the chip for detecting a biological substance, in which
   each of the pixels includes at least a holding surface for holding the biological substance and a photoelectric conversion unit that is provided below the holding surface and on a semiconductor substrate, and
   a color-mixture suppressing unit is provided between the pixels.

### Reference Signs List

- 1: chip for detecting a biological substance

- 11: pixel
- S: biological substance
- 111: holding surface
- 12: semiconductor substrate
- 112: photoelectric conversion unit
- 13: color-mixture suppressing unit
- 112A: photoelectric conversion region
- 13T: trench
- 14: oxide film
- 15: metal
- 111C: recessed portion
- 16: film
- 17: light-shielding film
- 18: on-chip lens
- 19: flattening film
- 20: protective layer
- 21: excitation light cut filter
- 22: intermediate region
- 23: wiring region
- 24: peripheral region
- 21: analysis unit
- 22: light irradiation unit
- 23: storage unit
- 24: display unit
- 25: temperature control unit
- 31: analysis device
- 32: light irradiation device
- 33: storage device
- 34: display device
- 35: temperature control device

## Claims

1. A chip for detecting a biological substance, comprising:
a plurality of pixels, wherein
each of the pixels includes at least a holding surface for holding the biological substance and a photoelectric conversion unit that is provided below the holding surface and on a semiconductor substrate, and
a color-mixture suppressing unit is provided between the pixels.

2. The chip for detecting a biological substance according to claim 1, wherein
the pixel and the color-mixture suppressing unit have different conductivity types.

3. The chip for detecting a biological substance according to claim 2, wherein
the pixel has an N-type region and the color-mixture suppressing unit has a P-type region.

4. The chip for detecting a biological substance according to claim 2, wherein
the pixel has a P-type region and the color-mixture suppressing unit has an N-type region.

5. The chip for detecting a biological substance according to claim 1, wherein
each of the plurality of pixels has a photoelectric conversion region, and a trench is provided between the respective photoelectric conversion regions.

6. The chip for detecting a biological substance according to claim 5, wherein
an interior of the trench includes one or more selected from an oxide film and a metal.

7. The chip for detecting a biological substance according to claim 1, wherein
a recessed portion is provided above the photoelectric conversion unit and on the holding surface.

8. The chip for detecting a biological substance according to claim 1, wherein
the holding surface is provided on a film formed on the semiconductor substrate.

9. The chip for detecting a biological substance according to claim 8, wherein
the film has a first refractive index and the semiconductor substrate has a second refractive index different from the first refractive index.

10. The chip for detecting a biological substance according to claim 8, wherein
the film includes one or more films selected from an inorganic film and an organic film.

11. The chip for detecting a biological substance according to claim 1, further comprising
light-shielding films provided above between the respective adjacent pixels.

12. The chip for detecting a biological substance according to claim 11, wherein
a space between the light-shielding films is formed to have one or more shapes selected from a circular shape, an elliptical shape, and a polygon having round corners in a top view.

13. The chip for detecting a biological substance according to claim 1, wherein
the holding surface is provided on an on-chip lens (OCL) provided on the semiconductor substrate.

14. The chip for detecting a biological substance according to claim 13, wherein
the holding surface is provided on a flattening film formed on the on-chip lens (OCL).

15. The chip for detecting a biological substance according to claim 13, wherein
the biological substance is one or more biological substances selected from nucleic acids, proteins, cells, microorganisms, chromosomes, liposomes, mitochondria, organelles, and complexes thereof.

16. A biological-substance detection apparatus, comprising:
a chip for detecting a biological substance including a plurality of pixels; and
an analysis unit that analyzes electric information acquired by the chip for detecting a biological substance, wherein
each of the pixels includes at least a holding surface for holding the biological substance and a photoelectric conversion unit that is provided below the holding surface and on a semiconductor substrate, and
a color-mixture suppressing unit is provided between the pixels.

17. A biological-substance detection system, comprising:
a chip for detecting a biological substance including a plurality of pixels; and
an analysis device that analyzes electric information acquired by the chip for detecting a biological substance, wherein
each of the pixels includes at least a holding surface for holding the biological substance and a photoelectric conversion unit that is provided below the holding surface and on a semiconductor substrate, and
a color-mixture suppressing unit is provided between the pixels.
